# EUROPEAN PATENT APPLICATION

(11) **EP 4 254 977 A1**
(43) Date of publication of application: **04.10.2023**
(21) Application number: 23705465.5
(22) Date of filing: 20.01.2023
(51) Int. Cl.: H04N 25/704, H04N 25/59, H04N 25/583, H04N 25/75, H04N 25/11, H04N 23/67, H01L 27/146, H04N 25/42

(54) **ELECTRONIC DEVICE COMPRISING IMAGE SENSOR AND OPERATING METHOD THEREOF**

(30) Priority: 21.01.2022 KR 20220009413; 30.05.2022 KR 20220066308
(71) Applicant: Samsung Electronics Co., Ltd., Suwon-si, Gyeonggi-do 16677 (KR)
(72) Inventor: KIM, Yunjeong, Suwon-si, Gyeonggi-do 16677 (KR); PARK, Jaehyoung, Suwon-si, Gyeonggi-do 16677 (KR); KANG, Kawang, Suwon-si, Gyeonggi-do 16677 (KR); KIM, Dongsoo, Suwon-si, Gyeonggi-do 16677 (KR); MOON, Inah, Suwon-si, Gyeonggi-do 16677 (KR); SHIMOKAWA, Shuichi, Suwon-si, Gyeonggi-do 16677 (KR); YOUN, Yeotak, Suwon-si, Gyeonggi-do 16677 (KR); KWON, Suhyog, Suwon-si, Gyeonggi-do 16677 (KR); SON, Youngbae, Suwon-si, Gyeonggi-do 16677 (KR); WON, Jonghoon, Suwon-si, Gyeonggi-do 16677 (KR)
(74) Representative: Nederlandsch Octrooibureau
(86) International application number: PCT/KR2023/000996
(87) International publication number: WO 2023/140678

(57) **Abstract**

According to an embodiment, an electronic device may include an image sensor including a plurality of unit pixels, and at least one processor electrically connected with the image sensor. Each unit pixel may include PDs disposed under a micro lens and having a 2x2 arrangement, that is, a TL, a TR, a BL, and a BR. The at least one processor may acquire a first image frame from the image sensor, determine an operation mode of the image sensor based on the first image frame, and may perform AF of an H direction by using TL, BL, or TL+BL AF data and TR, BR, or TR+BR AF data, or may perform AF of a V direction by using TL, TR, or TL+TR AF data and BL, BR, or BL+BR AF data according to an operation mode of the image sensor. Various other embodiments understood through the specification are possible.

## Description

### [Technical Field]

The disclosure relates to a technology for performing an auto focus (AF) function in an electronic device including an image sensor.

### [Background Art]

As a high-resolution mode is increasingly required, methods for enhancing AF performance by using an image sensor are being proposed. Recently, image sensors are being developed with the aim of reducing sizes of pixels and increasing the number of pixels due to restrictions on a camera mounting structure. In particular, as image sensors having not only a high-pixel mode but also high AF performance are required, a pixel structure capable of detecting phase differences of all pixels is being proposed.

An electronic device employing a related-art AF method includes an image sensor in which two photodiodes (PDs) having a 2x1 arrangement are disposed under one micro lens, and performs an AF function by classifying AF data outputted from each PD into left data and right data and focusing by using a phase difference between the two data. However, as the size of the PD is reduced and there is an increasing demand for a structure having a high resolution, a structure in which four PDs having a 2x2 arrangement rather than a 2x1 arrangement share one micro lens is being proposed. In this case, with the advantage of having a high resolution, there is an advantage that AF performance is further enhanced because phase differences in a horizontal direction and a vertical direction are known.

### [Disclosure of Invention]

### [Technical Problem]

In an image sensor including PDs having an MxN arrangement, a direction in which data is read out from the PDs may be fixed. That is, the image sensor may include N analog-digital converts (ADCs) corresponding to respective columns of the PDs, and may read out data from N PDs of a row selected from PDs of M rows, respectively, and may convert the data into digital signals at the ADCs. Accordingly, the direction in which data is read out from the PDs may be fixed to a specific direction (for example, a horizontal direction) due to the hardware structure of the image sensor. For example, the image sensor may read out data from the leftmost PD to the rightmost PD in sequence among the PDs of the selected row.

When AF of a horizontal direction (hereinafter, horizontal AF) is performed in an electronic device including an image sensor of a 4PD structure, a direction in which data is read out from PDs of the image sensor (for example, the horizontal direction) and a direction in which a phase difference is detected (for example, the horizontal direction) may be parallel to each other. Accordingly, the electronic device may perform calculation for the horizontal AF in order of reading out from the PDs. However, when AF of a vertical direction (hereinafter, vertical AF) is performed in the electronic device, the direction in which data is read out from the PDs of the image sensor (for example, the horizontal direction) and a direction in which a phase difference is detected may be different from each other. Accordingly, even when the electronic device reads out from PDs of a specific row, the electronic device may not perform calculation for the vertical AF until the electronic device reads out from PDs of the next row. Accordingly, a memory capacity required for the vertical AF may increase, a calculation speed may be reduced, and power consumption may increase.

### [Solution to Problem]

According to an embodiment of the disclosure, an electronic device may include an image sensor including a plurality of unit pixels, and at least one processor electrically connected with the image sensor. A first unit pixel of the plurality of unit pixels may include: a micro lens; and a first photodiode (PD), a second PD disposed in a first direction of the first PD, a third PD disposed in a second direction of the first PD, and a fourth PD disposed in the second direction of the second PD, the first PD, the second PD, the third PD, and the fourth PD being disposed under the micro lens. The at least one processor may: acquire a first image frame from the image sensor; determine an operation mode of the image sensor, based on information related to at least part of the first image frame; in response to the operation mode of the image sensor being determined to a first mode, control the image sensor to output first auto focus (AF) data corresponding to a quantity of light inputted to at least one PD of the first PD or the third PD, and second AF data corresponding to a quantity of light inputted to at least one PD of the second PD or the fourth PD, and perform an AF function based on a first phase difference of the first direction which is acquired based on the first AF data and the second AF data; and, in response to the operation mode of the image sensor being determined to a second mode, control the image sensor to output third AF data corresponding to a quantity of light inputted to at least one PD of the first PD or the second PD, and fourth AF data corresponding to a quantity of light inputted to at least one PD of the third PD or the fourth PD, and perform an AF function based on a second phase difference of the second direction which is acquired based on the third AF data and the fourth AF data.

According to an embodiment of the disclosure, an operating method of an electronic device may include: acquiring a first image frame through an image sensor, the image sensor including a plurality of unit pixels, a first unit pixel of the plurality of unit pixels including: a first PD, a second PD disposed in a first direction of the first PD, a third PD disposed in a second direction of the first PD, and a fourth PD disposed in the second direction of the second PD; determining an operation mode of the image sensor, based on information related to at least part of the first image frame; in response to the operation mode of the image sensor being determined to a first mode, controlling the image sensor to output first AF data corresponding to a quantity of light inputted to at least one PD of the first PD or the third PD, and second AF data corresponding to a quantity of light inputted to at least one PD of the second PD or the fourth PD, and performing an AF function based on a first phase difference of the first direction which is acquired based on the first AF data and the second AF data; and, in response to the operation mode of the image sensor being determined to a second mode, controlling the image sensor to output third AF data corresponding to a quantity of light inputted to at least one PD of the first PD or the second PD, and fourth AF data corresponding to a quantity of light inputted to at least one PD of the third PD or the fourth PD, and performing an AF function based on a second phase difference of the second direction which is acquired based on the third AF data and the fourth AF data.

According to an embodiment of the disclosure, an electronic device may include: an image sensor including a plurality of unit pixels; and at least one processor electrically connected with the image sensor. A first unit pixel of the plurality of unit pixels may include a first PD, a second PD disposed in a first direction of the first PD, a third PD disposed in a second direction of the first PD, and a fourth PD disposed in the second direction of the second PD, and the at least one processor may: acquire a first image frame from the image sensor; determine an operation mode of the image sensor, based on the first image frame, in response to the operation mode of the image sensor being determined to a first mode, control the image sensor to output first H-AF data which is acquired by reading out from the first PD and the third PD, and second H-AF data which is acquired by reading out from the second PD and the fourth PD, and perform an auto focus (AF) function based on a first phase difference of the first direction which is acquired based on the first H-AF data and the second H-AF data; and, in response to the operation mode of the image sensor being determined to a second mode, control the image sensor to output first V-AF data which is acquired by reading out from the first PD and the second PD, and second V-AF data which is acquired by reading out from the third PD and the fourth PD, and perform an AF function based on a second phase difference of the second direction which is acquired based on the first V-AF data and the second V-AF data

### [Advantageous Effects of Invention]

According to various embodiments of the disclosure, the image sensor may process and output data for performing vertical AF, so that the electronic device may easily perform vertical AF. In addition, the electronic device may focus on a subject by using not only horizontal AF but also vertical AF, so that AF performance may be enhanced.

According to various embodiments, since the electronic device performs vertical AF only when vertical AF is required. Therefore, a memory capacity required to perform an AF function may be reduced, a calculation speed may increase (for example, a calculation delay is reduced), and power consumption may be reduced. For example, the electronic device may appropriately use horizontal AF and/or vertical AF according to a subject, and accordingly, unnecessary calculation may be reduced during calculation for performing the AF function. In addition, the image sensor may selectively change information outputted according to use of horizontal AF and/or vertical AF.

The effect achieved by the disclosure is not limited to those mentioned above, and other effects that are not mentioned above may be clearly understood to those skilled in the art based on the description provided below.

### [Brief Description of Drawings]

FIG. 1 illustrates a block diagram of an electronic device in a network environment according to various embodiments;
FIG. 2 is a block diagram illustrating a camera module according to various embodiments;
FIG. 3 is a block diagram illustrating a hardware configuration included in an electronic device according to an embodiment;
FIG. 4 is a view illustrating an example of an image sensor and a unit pixel included in the image sensor according to an embodiment;
FIG. 5 is a view illustrating a unit pixel as viewed from one side according to an embodiment;
FIG. 6 illustrates a circuitry diagram of a unit pixel of an image sensor according to an embodiment;
FIG. 7 is a view illustrating examples of blocks performing calculation for performing an AF function in an image sensor according to an embodiment;
FIG. 8 is a view illustrating an example of data that is outputted or acquired by an image sensor and a processor in a first mode and a second mode, respectively;
FIG. 9 is a flowchart illustrating a flow of operations of performing horizontal AF or vertical AF by the processor according to an embodiment;
FIG. 10 is a flowchart illustrating a flow of operations performed by the image sensor in the first mode;
FIG. 11 is a flowchart illustrating a flow of operations performed by the image sensor in the second mode according to an embodiment; and
FIG. 12 is a flowchart illustrating a flow of operations performed by the image sensor in the third mode according to an embodiment.

Regarding descriptions of the drawings, the same or similar reference numerals may be used for the same or similar components.

### [Best Mode for Carrying out the Invention]

Hereinafter, various embodiments of the disclosure will be described with reference to the accompanying drawings. However, it should be appreciated that various embodiments are not intended to limit the disclosure to particular embodiments and include various modifications, equivalents, and/or alternatives of an embodiment of the disclosure.

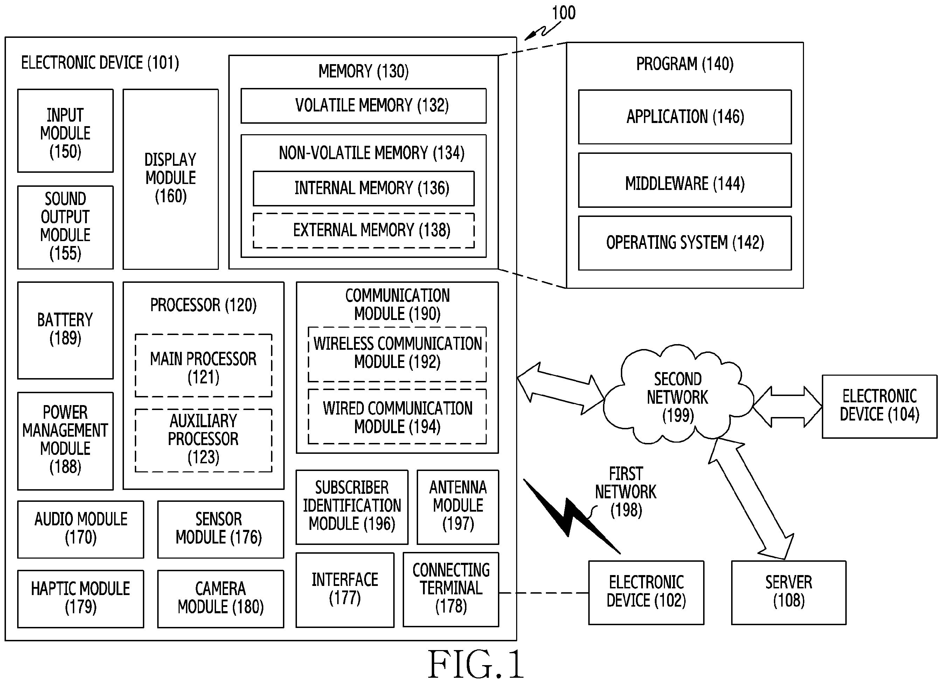

Fig. 1 illustrates a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semisupervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wirelessfidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mm Wave antenna module. According to an embodiment, the mm Wave antenna module may include a printed circuit board, a RFIC disposed on a first surface (e.g., the bottom surface) of the printed circuit board, or adjacent to the first surface and capable of supporting a designated high-frequency band (e.g., the mm Wave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an interperipheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

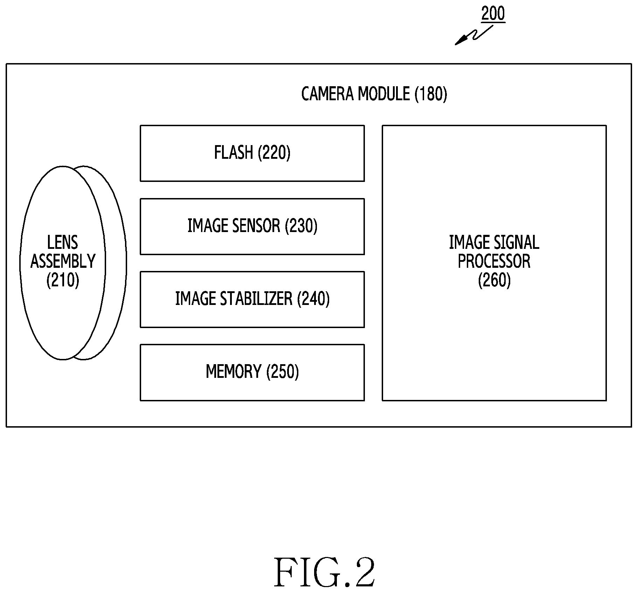

Fig. 2 is a block diagram 200 illustrating the camera module 180 according to various embodiments. Referring to Fig. 2, the camera module 180 may include a lens assembly 210, a flash 220, an image sensor 230, an image stabilizer 240, memory 250 (e.g., buffer memory), or an image signal processor 260. The lens assembly 210 may collect light emitted or reflected from an object whose image is to be taken. The lens assembly 210 may include one or more lenses.

According to an embodiment, the camera module 180 may include a plurality of lens assemblies 210. In such a case, the camera module 180 may form, for example, a dual camera, a 360-degree camera, or a spherical camera. Some of the plurality of lens assemblies 210 may have the same lens attribute (e.g., view angle, focal length, auto-focusing, f number, or optical zoom), or at least one lens assembly may have one or more lens attributes different from those of another lens assembly. The lens assembly 210 may include, for example, a wide-angle lens or a telephoto lens.

The flash 220 may emit light that is used to reinforce light reflected from an object. According to an embodiment, the flash 220 may include one or more light emitting diodes (LEDs) (e.g., a red-green-blue (RGB) LED, a white LED, an infrared (IR) LED, or an ultraviolet (UV) LED) or a xenon lamp. The image sensor 230 may obtain an image corresponding to an object by converting light emitted or reflected from the object and transmitted via the lens assembly 210 into an electrical signal.

According to an embodiment, the image sensor 230 may include one selected from image sensors having different attributes, such as a RGB sensor, a black-and-white (BW) sensor, an IR sensor, or a UV sensor, a plurality of image sensors having the same attribute, or a plurality of image sensors having different attributes. Each image sensor included in the image sensor 230 may be implemented using, for example, a charged coupled device (CCD) sensor or a complementary metal oxide semiconductor (CMOS) sensor.

The image stabilizer 240 may move the image sensor 230 or at least one lens included in the lens assembly 210 in a particular direction, or control an operational attribute (e.g., adjust the read-out timing) of the image sensor 230 in response to the movement of the camera module 180 or the electronic device 101 including the camera module 180. This allows compensating for at least part of a negative effect (e.g., image blurring) by the movement on an image being captured. According to an embodiment, the image stabilizer 240 may sense such a movement by the camera module 180 or the electronic device 101 using a gyro sensor (not shown) or an acceleration sensor (not shown) disposed inside or outside the camera module 180. According to an embodiment, the image stabilizer 240 may be implemented, for example, as an optical image stabilizer. The memory 250 may store, at least temporarily, at least part of an image obtained via the image sensor 230 for a subsequent image processing task. For example, if image capturing is delayed due to shutter lag or multiple images are quickly captured, a raw image obtained (e.g., a Bayer-patterned image, a high-resolution image) may be stored in the memory 250, and its corresponding copy image (e.g., a low-resolution image) may be previewed via the display module 160. Thereafter, if a specified condition is met (e.g., by a user's input or system command), at least part of the raw image stored in the memory 250 may be obtained and processed, for example, by the image signal processor 260. According to an embodiment, the memory 250 may be configured as at least part of the memory 130 or as a separate memory that is operated independently from the memory 130.

The image signal processor 260 may perform one or more image processing with respect to an image obtained via the image sensor 230 or an image stored in the memory 250. The one or more image processing may include, for example, depth map generation, three-dimensional (3D) modeling, panorama generation, feature point extraction, image synthesizing, or image compensation (e.g., noise reduction, resolution adjustment, brightness adjustment, blurring, sharpening, or softening). Additionally or alternatively, the image signal processor 260 may perform control (e.g., exposure time control or read-out timing control) with respect to at least one (e.g., the image sensor 230) of the components included in the camera module 180. An image processed by the image signal processor 260 may be stored back in the memory 250 for further processing, or may be provided to an external component (e.g., the memory 130, the display module 160, the electronic device 102, the electronic device 104, or the server 108) outside the camera module 180. According to an embodiment, the image signal processor 260 may be configured as at least part of the processor 120, or as a separate processor that is operated independently from the processor 120. If the image signal processor 260 is configured as a separate processor from the processor 120, at least one image processed by the image signal processor 260 may be displayed, by the processor 120, via the display module 160 as it is or after being further processed.

According to an embodiment, the electronic device 101 may include a plurality of camera modules 180 having different attributes or functions. In such a case, at least one of the plurality of camera modules 180 may form, for example, a wide-angle camera and at least another of the plurality of camera modules 180 may form a telephoto camera. Similarly, at least one of the plurality of camera modules 180 may form, for example, a front camera and at least another of the plurality of camera modules 180 may form a rear camera.

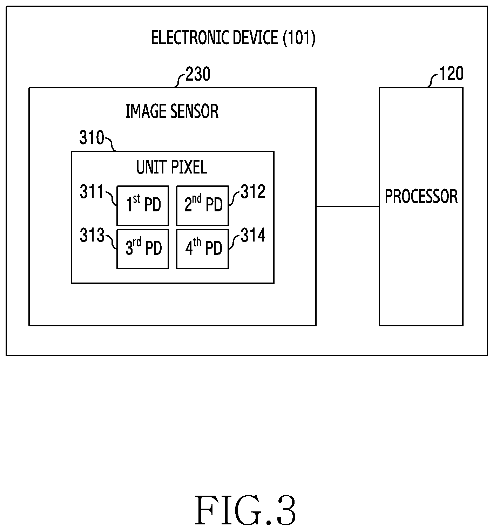

FIG. 3 is a block diagram illustrating a hardware configuration included in an electronic device according to an embodiment.

Referring to FIG. 3, the electronic device 101 may include an image sensor 230 and a processor 120. The electronic device 101 may correspond to the electronic device 101 of FIG. 1, the processor 120 may correspond to the processor 120 of FIG. 1, and the image sensor 230 may correspond to the image sensor 230 of FIG. 2.

According to an embodiment, the image sensor 230 may be a complementary metal oxide semiconductor (CMOS) sensor. The image sensor 230 may convert light inputted to each pixel into an electrical signal.

According to an embodiment, the image sensor 230 may include a plurality of unit pixels 310. According to an embodiment, the unit pixel 310 may include a first photodiode (PD) 311, a second PD 312, a third PD 313, and a fourth PD 314. The first PD 311, the second PD 312, the third PD 313, and the fourth PD 314 may have a 2x2 arrangement. The second PD 312 may be disposed in a first direction (for example, the right) of the first PD 311, the third PD 313 may be disposed in a second direction (for example, under or down) of the first PD 311, and the fourth PD 314 may be disposed in the second direction (for example, under) of the second PD 312.

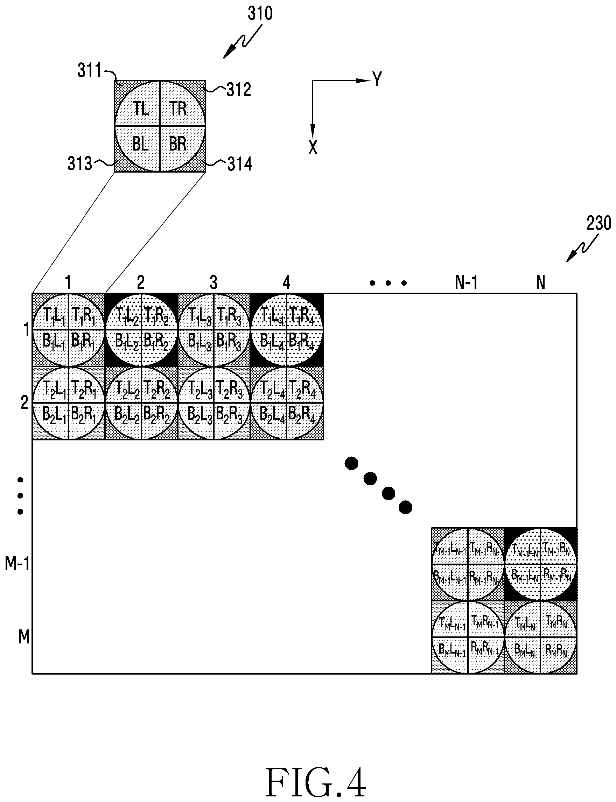

According to an embodiment, the plurality of unit pixels 310 may be integrated into the image sensor 230, and each unit pixel 310 may include a micro lens, a color filter, and two or more PDs. Regarding the configuration of the unit pixel 310, reference will be made to FIGS. 4 to 6.

According to an embodiment, it may be understood that the processor 120 includes at least one processor. For example, the processor 120 may include at least one of an application processor (AP), an image signal processor (ISP), or a communication processor (CP).

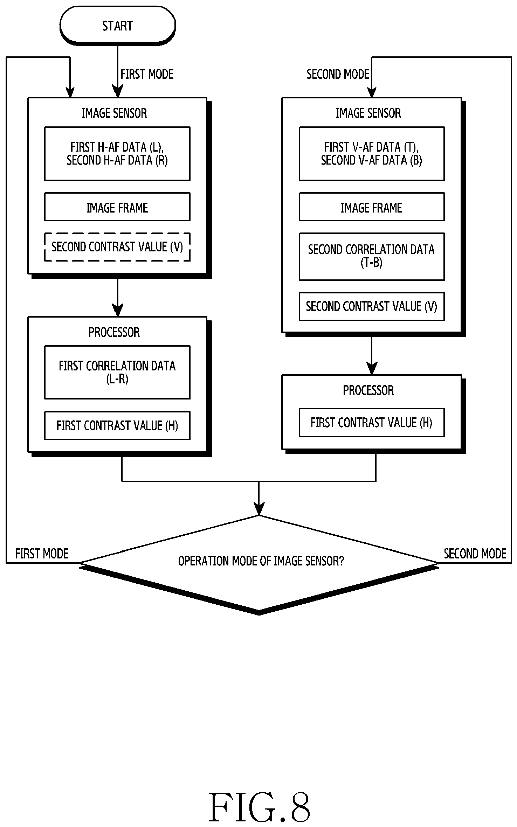

According to an embodiment, the processor 120 may acquire an image frame through the image sensor 230. The processor 120 may determine an operation mode of the image sensor 230 based on the image frame, and may control operations of the image sensor 230 according to the determined operation mode. The operation mode of the image sensor 230 will be described with reference to FIGS. 8 to 12.

FIG. 4 illustrates an example of an image sensor and a unit pixel included in the image sensor according to an embodiment.

According to an embodiment, the image sensor 230 may include a plurality of unit pixels 310. For example, the plurality of unit pixels 310 may be disposed on a plane (for example, a x-y plane) that is substantially perpendicular to an optical axis. In the disclosure, a first direction may indicate a +y axis direction and a second direction may indicate a +x axis direction.

According to an embodiment, the unit pixel 310 may include a first PD 311, a second PD 312, a third PD 313, and a fourth PD 314. In the disclosure, the first PD 311 may be referred to as a TL, the second PD 312 may be referred to as a TR, the third PD 313 may be referred to as a BL, and the fourth PD 314 may be referred to as a BR. The first PD 311, the second PD 312, the third PD 313, and the fourth PD 314 may be understood as or may be referred to as individual pixels or sub-pixels.

According to an embodiment, the image sensor 230 may include the plurality of unit pixels 310 into which light of different colors is inputted. For example, a unit pixel in the first column of the first row may acquire an electrical signal corresponding to green light, a unit pixel in the second column of the first row may acquire an electrical signal corresponding to red light, a unit pixel in the first column of the second row may acquire an electrical signal corresponding to blue light, a unit pixel in the second column of the second row may acquire an electrical signal corresponding to green light. The color of a color filter included in the unit pixel in the first column of the first row may be different from the color of a color filter included in the unit pixel in the second column of the first row.

According to an embodiment, the image sensor 230 may include unit pixels 310 having a MxN arrangement. The image sensor 230 may include N ADCs corresponding to N columns. According to an embodiment, when binning is performed with respect to the first PD 311, the second PD 312, the third PD 313, and the fourth PD 314, the image sensor 230 may read out from unit pixels 310 of each row in sequence from the first column to the N-th column. According to an embodiment, when data is read out from the first PD 311, the second PD 312, the third PD 313, and the fourth PD 314, respectively, the image sensor 230 may read out in order of T₁L₁, T₁R₁, T₁L₂, T₁R₂, T₁L₃, T₁R₃, ..., T₁L_{N}, T₁R_{N}, B₁L₁, B₁R₁, B₁L₂, B₁R₂, B₁L₃, B₁R₃, ..., B₁L_{N}, B₁R_{N}. However, the number of ADCs is merely an example and is not limited thereto, and various embodiments are possible in addition to the embodiment of the N ADCs. For example, the image sensor 230 may be configured such that one ADC is connected to every two columns among the N columns, and accordingly, the image sensor 230 may include N/2 ADCs. Although FIG. 4 illustrates that each unit pixel 310 included in the image sensor 230 includes 4 PDs, this is merely an example and various embodiments are possible. For example, each unit pixel 310 may include 9 PDs having a 3x3 arrangement, or may include 6 PDs having a 2x3 arrangement. Various other embodiments are possible.

In addition, although FIG. 4 illustrates that each unit pixel corresponds to a color filter of a different color, various other embodiments are possible. For example, the image sensor may be configured such that a first unit pixel, a second unit pixel disposed in the first direction (i.e., +y axis direction) of the first unit pixel, a third unit pixel disposed in the second direction (i.e., +x axis direction) of the first unit pixel, and a fourth unit pixel disposed in the second direction (i.e., +x axis direction) of the second unit pixel have color filters of the same color. That is, four unit pixels each of which includes four PDs (that is, 16 PDs) may correspond to color filters of one color.

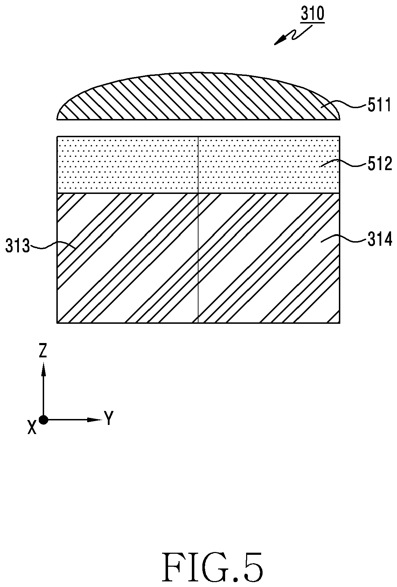

FIG. 5 illustrates a unit pixel as viewed from one side according to an embodiment. The unit pixel illustrated in FIG. 5 is one example and the disclosure may be applied to various unit pixels including a structure in which a phase difference of light entering PDs is separated. For example, the disclosure may be applied to an electronic device from which some of the components of FIG. 5 are omitted.

According to an embodiment, the unit pixel 310 may include a micro lens 511, a color filter 512, and PDs (for example, a first PD 311, a second PD 312, a third PD 313, a fourth PD 314). FIG. 5 illustrates the unit pixel 310 as viewed in the +x direction, and accordingly, the first PD 311 and the second PD 312 are not illustrated.

According to an embodiment, the first PD 311, the second PD 312, the third PD 313, and the fourth PD 314 may be disposed under one micro lens 511. The micro lens 511 illustrated in FIG. 5 may be referred to as a 2x2 on chip lens (OCL). According to an embodiment, the micro lens 511 may collect light entering the unit pixel 310. The light collected at the unit pixel 310 may be distributed to the first PD 311, the second PD 312, the third PD 313, and the fourth PD 314 along a path of incident light.

According to an embodiment, the first PD 311, the second PD 312, the third PD 313, and the fourth PD 314 may share the color filter 512 of the same color. The color filter 512 may allow light of a designated wavelength range to pass therethrough. For example, the color filter 512 may allow light of a wavelength range corresponding to green light to pass therethrough, and the first PD 311, the second PD 312, the third PD 313, and the fourth PD 314 may acquire light quantity data corresponding to a quantity of green light. According to an embodiment, the image sensor 230 may include unit pixels 310 including color filters 512 of different colors according to a designated pattern (for example, a Bayer pattern).

According to an embodiment, the first PD 311, the second PD 312, the third PD 313, and the fourth PD 314 may output values corresponding to incident light, respectively. The PDs 311, 312, 313, 314 may output values corresponding to incident light, based on the photoelectric effect. The PDs 311, 312, 313, 314 may output a value corresponding to an intensity of incident light or a quantity of incident light. For example, each of the PDs 311, 312, 313, 314 may generate an electric charge corresponding to a quantity of incident light, and may output a current according to an amount of generated electric charge.

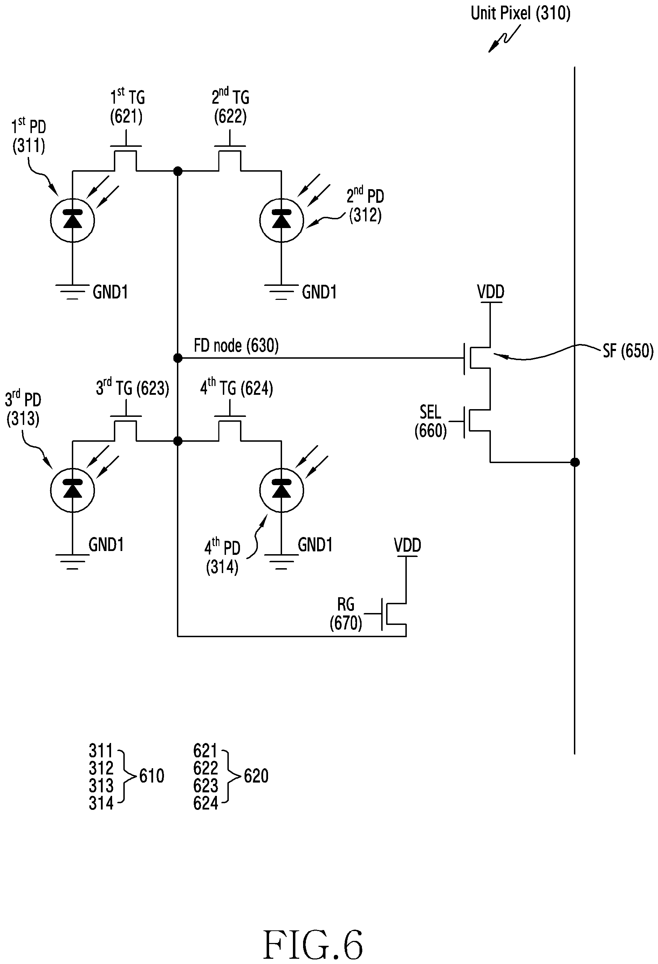

FIG. 6 illustrates a circuitry diagram of a unit pixel of an image sensor according to an embodiment.

According to an embodiment, the unit pixel 310 may include PDs 610, transfer gates (TGs) 620 corresponding to the PDs 610, respectively, a floating diffusion (FD) node 630, a source follower (SF) 650, a row select (hereinafter, SEL) 660, and a reset gate (RG) 670. GND1 illustrated in FIG. 6 may indicate a ground power source and VDD may indicate a power voltage.

According to an embodiment, the unit pixel 310 may include four PDs 610. For example, the unit pixel 310 may include four PDs (for example, a first PD 311, a second PD 312, a third PD 313, and a fourth PD 314) having a 2x2 arrangement. According to an embodiment, the unit pixel 310 may include four PDs 610 having a 2x2 arrangement and one FD node 630 connected with the four PDs 610. For example, the unit pixel 310 may refer to a micro lens unit or a color filter unit. According to an embodiment, the unit pixel 310 may include five or more PDs 610. For example, the unit pixel 310 may include 9 PDs 610 having a 3x3 arrangement. The unit pixel 310 may include 9 PDs 610 having a 3x3 arrangement and one FD node 630 connected with the 9 PDs 610. For example, the unit pixel 310 may include 16 PDs 610 having a 4x4 arrangement, or may include 8 PDs 610 having a 2x4 arrangement. The disclosure is described on the assumption that the unit pixel 310 includes 4 PDs 610 having a 2x2 arrangement, but this is one example and various embodiments implementable by a person skilled in the art are possible.

According to an embodiment, an electric charge accumulated in the PD 610 for an exposure time may be moved to the FD node 630 when the TG 620 is in an on-state. For example, an electric charge accumulated in the first PD 311 may be moved to the FD node 630 when a first TG 621 is in an on-state. According to an embodiment, the image sensor 230 may acquire analogue data corresponding to the electric charge moved to the FD node 630. For example, the analogue data may include information on a quantity of electric charge accumulated in the PD 610 for the exposure time.

According to an embodiment, the image sensor 230 may acquire analogue data through an individual pixel (for example, each PD 610) or the unit pixel 310. For example, the image sensor 230 may acquire analogue data corresponding to light quantity data acquired through at least one of the PDs 610 by controlling the TG 620. For example, the image sensor 230 may acquire light quantity data through the first PD 311, the second PD 312, the third PD 313, and the fourth PD 314 for the exposure time. When the image sensor 230 switches the first TG 621 into an on-state, the image sensor 230 may acquire analogue data based on light quantity data acquired through the first PD 311. When the image sensor 230 switches the first TG 621, the second TG 622, the third TG 623, and the fourth TG 624 to an on-state, the image sensor 230 may acquire analogue data based on light quantity data acquired through the first PD 311, the second PD 312, the third PD 313, and the fourth PD 314.

In an embodiment, the image sensor 230 may acquire analogue data based on light quantity data acquired through any one of the four PDs 610. In an embodiment, the image sensor 230 may acquire analogue data based on light quantity data acquired through two PDs of the four PDs 610. For example, the image sensor 230 may switch the first TG 621 and the third TG 623 into an on-state, and may acquire analogue data corresponding to a quantity of light inputted to the first PD 311 and the third PD 313. In an embodiment, the image sensor 230 may acquire analogue data based on light quantity data acquired through the four PDs 610. In the disclosure, the operation of switching two or more TGs 620 into an on-state and acquiring analogue data corresponding to a quantity of light inputted to two or more PDs 610 may be referred to as an analogue sum.

According to an embodiment, an electric charge stored in the FD node 630 may be read out through the SF 650 and may be outputted as an electric signal. According to an embodiment, the image sensor 230 may digitally convert the analogue data through an ADC, thereby acquiring digital data.

According to an embodiment, the image sensor 230 may change the state of the SEL 660 from an off-state to an on-state in order to output image data of a specific row.

According to an embodiment, the image sensor 230 may perform a correlated double sampling (CDS) operation in order to reduce a noise. For example, the image sensor 230 may switch the RG 670 into an on-state to reset data accumulated in the FD node 630, and may read out reset data remaining after resetting. The image sensor 230 may switch the RG 670 into an off-state and then may move an electric charge accumulated in the PD 610 to the FD node 630, and may read out the electric charge moved to the FD node 630. The image sensor 230 may acquire the digital data based on a difference between the results of reading out two times.

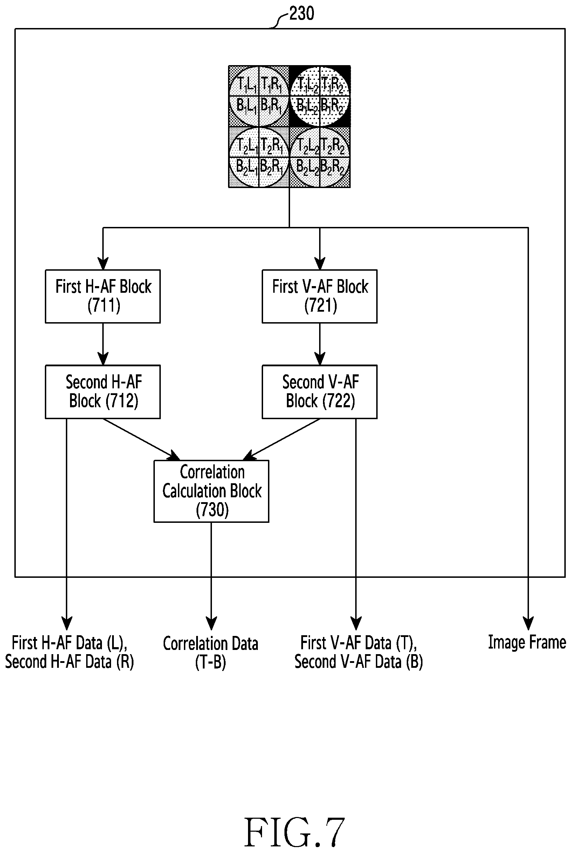

FIG. 7 illustrates examples of blocks for performing calculation for performing an AF function in the image sensor according to an embodiment.

Referring to FIG. 7, the image sensor 230 may include blocks for performing calculation related to the AF function, based on data (for example, digital data) outputted from the unit pixels 310. For example, the image sensor 230 may include a first H-AF block 711, a second H-AF block 712, a first V-AF block 721, a second V-AF block 722, and a correlation calculation block 730. In an embodiment, the blocks illustrated in FIG. 7 may be a hardware configuration included in the image sensor 230. In an embodiment, at least some of the blocks illustrated in FIG. 7 may be a software module that is included in a control circuit included in the image sensor 230 or is implemented by the control circuit. According to an embodiment, some of the blocks illustrated in FIG. 7 may be omitted and two or more blocks may be integrated into one block.

According to an embodiment, the image sensor 230 may acquire first readout data, second readout data, third readout data, and fourth readout data by reading out from PDs (for example, T₁L₁, T₁R₁, B₁R₁, B₁R₁) included in the unit pixel 310. For example, the image sensor 230 may acquire first readout data corresponding to a quantity of light inputted to the first PD 311 (for example, T₁L₁), second readout data corresponding to a quantity of light inputted to the second PD 312 (for example, T₁R₁), third readout data corresponding to a quantity of light inputted to the third PD 313 (for example, B₁L₁), and fourth readout data corresponding to a quantity of light inputted to the fourth PD 314 (for example, B₁R₁). The readout data in the disclosure may correspond to digital data or analogue data described in relation with FIG. 6.

According to an embodiment, the first H-AF block 711 may add the first readout data and the third readout data. For example, the first H-AF block 711 may add pixel data corresponding to the first PD 311 (for example, T₁L₁) and pixel data corresponding to the third PD 313 (for example, B₁L₁). In addition, the first H-AF block 711 may add the second readout data and the fourth readout data. For example, the first H-AF block 711 may add pixel data corresponding to the second PD 312 (for example, T₁R₁) and pixel data corresponding to the fourth PD 314 (for example, B₁R₁). According to an embodiment, the first H-AF block 711 may output data corresponding to T₁L₁+B₁L₁, T₁R₁+B₁R₁, T₁L₂+B₁L₂, T₁R₂+B₁R₂, T₂L₁+B₂L₁, T₂R₁+B₂R₁, T₂L₂+B₂L₂, and T₂R₂+B₂R₂.

According to an embodiment, the second H-AF block 712 may acquire first H-AF data and second H-AF data based on data outputted from the first H-AF block 711. According to an embodiment, the second H-AF block 712 may acquire, from the image sensor 230 (for example, the unit pixels 310), the first H-AF data corresponding to the left PDs (for example, T₁L₁, B₁L₁, T₁L₂, B₁L₂, T₂L₁, B₂L₁, T₂L₂, B₂L₂), and the second H-AF data corresponding to the right PDs (T₁R₁, B₁R₁, T₁R₂, B₁R₂, T₂R₁, B₂R₁, T₂R₂, B₂R₂). For example, the second H-AF block 712 may acquire the first H-AF data by adding T₁L₁+B₁L₁, T₁L₂+B₁L₂, T₂L₁+B₂L₁, and T₂L₂+B₂L₂ corresponding to the left PDs among data outputted by the first H-AF block 711. The first H-AF data may be data corresponding to T₁L₁+B₁L₁+T₁L₂+B₁L₂+T₂L₁+B₂L₁+T₂L₂+B₂L₂. In addition, for example, the second H-AF block 712 may acquire the second H-AF data by adding T₁R₁+B₁R₁, T₁R₂+B₁R₂, T₂R₁+B₂R₁, and T₂R₂+B₂R₂ corresponding to the right PDs among data outputted by the first H-AF block 711. The second H-AF data may be data corresponding to T₁R₁+B₁R₁+T₁R₂+B₁R₂+T₂R₁+B₂R₁+T₂R₂+B₂R₂. The first H-AF data and the second H-AF data may be data that is processed in the form of luminance.

According to an embodiment, in a first mode, the image sensor 230 may output the first H-AF data corresponding to the left PDs and the second H-AF data corresponding to the right PDs, based on results of calculation of the first H-AF block 711 and the second H-AF block 712. In the first mode, the image sensor 230 may provide the first H-AF data and the second H-AF data to the processor 120.

According to an embodiment, the first V-AF block 721 may add the first readout data and the second readout data. For example, the first V-AF block 721 may add pixel data corresponding to the first PD 311 (for example, T₁L₁), and pixel data corresponding to the second PD 312 (for example, T₁R₁). In addition, the first V-AF block 721 may add the third readout data and the fourth readout data. For example, the first V-AF block 721 may add pixel data corresponding to the third PD 313 (for example, B₁L₁) and pixel data corresponding to the fourth PD 314 (for example, B₁R₁). According to an embodiment, the first V-AF block 721 may output data corresponding to T₁L₁+T₁R₁, B₁L₁+B₁R₁, T₁L₂+T₁R₂, B₁L₂+B₁R₂, T₂L₁+T₂R₁, B₂L₁+B₂R₁, T₂L₂+T₂R₂, and B₂L₂+B₂R₂.

According to an embodiment, the second V-AF block 722 may acquire first V-AF data and second V-AF data based on data outputted from the first V-AF block 721. According to an embodiment, the second V-AF block 722 may acquire, from the four unit pixels 310, the first V-AF data corresponding to the upper PDs (T₁L₁, T₁R₁, T₁L₂, T₁R₂, T₂L₁, T₂R₁, T₂L₂, T₂R₂), and the second H-AF data corresponding to the lower PDs (B₁L₁, B₁R₁, B₁L₂, B₁R₂, B₂L₁, B₂R₁, B₂L₂, B₂R₂). For example, the second V-AF block 722 may acquire the first V-AF data by adding T₁L₁+T₁R₁, T₁L₂+T₁R₂, T₂L₁+T₂R₁, and T₂L₂+T₂R₂ corresponding to the upper PDs among data outputted by the first V-AF block 721. The first V-AF data may be data corresponding to T₁L₁+T₁R₁+T₁L₂+T₁R₂+T₂L₁+T₂R₁+T₂L₂+T₂R₂. In addition, for example, the second V-AF block 722 may acquire the second V-AF data by adding B₁L₁+B₁R₁, B₁L₂+B₁R₂, B₂L₁+B₂R₁, and B₂L₂+B₂R₂ corresponding to the lower PDs among data outputted by the first V-AF block 721. The second V-AF data may be data corresponding to B₁L₁+B₁R₁+B₁L₂+B₁R₂+B₂L₁+B₂R₁+B₂L₂+B₂R₂. The first V-AF data and the second V-AF data may be data that is processed in the form of luminance.

According to an embodiment, in a second mode, the image sensor 230 may output the first V-AF data corresponding to the upper PDs and the second V-AF data corresponding to the lower PDs, based on results of calculation of the first V-AF block 721 and the second V-AF block 722. The image sensor 230 may provide the first V-AF data and the second V-AF data to the processor 120 in the second mode.

According to an embodiment, the image sensor 230 may not individually read out from the PDs (for example, T₁L₁, T₁R₁, B₁L₁, B₁R₁, etc.) included in the unit pixel 310. The image sensor 230 may read out from two PDs among the PDs included in the unit pixel 310 concurrently.

According to an embodiment, the image sensor 230 may read out from the first PD 311 and the third PD 313, and may read out from the second PD 312 and the fourth PD 314. For example, the image sensor 230 may switch the first TG 621 and the third TG 623 into an on-state after exposing the PD 610, and may read out from the first PD 311 and the third PD 313 concurrently. That is, the image sensor 230 may read out from the first PD 311 and the third PD 313 (for example, read out through an FD sum (or analog sum)) through the FD node 630. In addition, the image sensor 230 may switch the second TG 624 and the fourth TG 624 into an on-state, and may read out from the second PD 312 and the fourth PD 314 concurrently. That is, the image sensor 230 may read out from the second PD 312 and the fourth PD 314 through the FD node 630 (for example, read out through an FD sum). According to an embodiment, when the image sensor 230 reads out from two PDs concurrently, the first H-AF block 711 may be bypassed and the second H-AF block 712 may be controlled to calculate.

According to an embodiment, the image sensor 230 may read out from the first PD 311 and the second PD 312, and may read out from the third PD 313 and the fourth PD 314. For example, the image sensor 230 may switch the first TG 621 and the second TG 623 into an on-state after exposing the PD 610, and may read out from the first PD 311 and the second PD 312 concurrently. That is, the image sensor 230 may read out from the first PD 311 and the second PD 312 (for example, read out through an FD sum (e.g., analog sum)) through the FD node 630. In addition, the image sensor 230 may switch the third TG 623 and the fourth TG 624 into an on-state, and may read out from the third PD 313 and the fourth PD 314 concurrently That is, the image sensor 230 may read out from the third PD 313 and the fourth PD 314 through the FD node 630 (for example, read out through an FD sum). According to an embodiment, when the image sensor 230 reads out from two PDs concurrently, the first V-AF block 721 may be bypassed and the second H-AF block 722 may be controlled to calculate.

According to an embodiment, the image sensor 230 may acquire a disparity of a vertical direction based on a result of output of the second V-AF block 722. For example, the image sensor 230 may acquire correlation data between the first V-AF data and the second V-AF data, based on the first V-AF data and the second V-AF data. The image sensor 230 may acquire the disparity of the vertical direction based on the correlation data between the first V-AF data and the second V-AF data. According to an embodiment, the image sensor 230 may output the correlation data between the first V-AF data and the second V-AF data, or may output the disparity between the first V-AF data and the second V-AF data.

According to an embodiment, when the processor 120 acquires the first H-AF data and the second H-AF data from the image sensor 230, the processor 120 may acquire correlation data between the first H-AF data and the second H-AF data (or a disparity between the first H-AF data and the second H-AF data, a disparity of the horizontal direction). However, even when the processor 120 acquires the first V-AF data and the second V-AF data from the image sensor 230, it may be difficult to acquire correlation data between the first V-AF data and the second V-AF data (or a disparity between the first V-AF data and the second V-AF data, a disparity of the vertical direction). For example, in order for the processor 120 to acquire the correlation of the vertical direction or disparity of the vertical direction, a delay of calculation may increase or a required storage capacity may increase. Accordingly, the image sensor 230 may acquire correlation data between the first V-AF data and the second V-AF data (or a disparity between the first V-AF data and the second V-AF data), and may provide the correlation data to the processor 120.

According to an embodiment, at least one of the operation of acquiring, by the image sensor 230, the correlation data between the first V-AF data and the second V-AF data, or the operation of acquiring, by the processor 120, the correlation data between the first H-AF data and the second H-AF data may be performed through any one of various correlation calculation methods. For example, various correlation calculation methods may include sum of the absolute difference (SAD), sum of squared differences (SSD), normalized cross-correlation (NCC), zero-mean normalized cross-correlation (ZNCC), census transform, and the absolute differences census transform: AD-Census). In addition, various correlation calculation methods may be used.

According to an embodiment, the image sensor 230 may read out from PDs included in the unit pixels 310 and may acquire a corresponding image frame. For example, the image sensor 230 may output an image frame acquired through 2x2 binning, or a remosaic image frame. The processor 120 may acquire an image frame related to AF data from the image sensor 230, along with the AF data (for example, the first H-AF data and the second H-AF data, or the first V-AF data and the second V-AF data) for performing an AF function.

According to an embodiment, the first H-AF data, the second H-AF data, the first V-AF data, and the second V-AF data may be referred to as first AF data, second AF data, third AF data, and fourth AF data, respectively.

According to an embodiment, unlike those explained in FIG. 7, the firstAF data (or the first H-AF data) may correspond to a quantity of light inputted to at least one PD of the first PD 311 or the third PD 313, the second AF data (or the second H-AF data) may correspond to a quantity of light inputted to at least one PD of the second PD 312 or the fourth PD 314, the third AF data (or the first V-AF data) may correspond to a quantity of light inputted to at least one PD of the first PD 311 or the second PD 312, and the fourth AF data (or the second V-AF data) may correspond to a quantity of light inputted to at least one PD of the third PD 313 or the fourth PD 314. That is, the image sensor 230 may provide AF data corresponding to a quantity of light acquired from two PDs of the unit pixel 310 to the processor 120, and may provide AF data corresponding to a quantity of light acquired from one PD to the processor 120.

According to an embodiment, the processor 120 may measure ambient illuminance of the electronic device 101, and may perform an AF operation by using AF data corresponding to two PDs included in the unit pixel 310 when the ambient illuminance of the electronic device 101 is less than a threshold value, and may perform an AF operation by using AF data corresponding to one PD included in the unit pixel 310 when the ambient illuminance of the electronic device 101 is greater than or equal to the threshold value. For example, when the ambient illuminance of the electronic device 101 is less than the threshold value, the processor 120 may control the image sensor 230 operating in the first mode to output the first AF data (or the first H-AF data) corresponding to quantities of light inputted to the first PD 311 and the third PD 313, and the second AF data (or the second H-AF data) corresponding to quantities of light inputted to the second PD 312 and the fourth PD 314. In addition, when the ambient illuminance of the electronic device 101 is greater than or equal to the threshold value, the processor 120 may control the image sensor 230 operating in the first mode to output the first AF data (or the first H-AF data) corresponding to a quantity of light inputted to the first PD 311 or the third PD 313, and the second AF data (or the second H-AF data) corresponding to a quantity of light inputted to the second PD 312 or the fourth PD 314. Likewise, when the ambient illuminance of the electronic device 101 is less than the threshold value, the processor 120 may control the image sensor 230 operating in the second mode to output the third AF data (or the first V-AF data) corresponding to quantities of light inputted to the first PD 311 and the second PD 312, and the fourth AF data (or the second V-AF data) corresponding to quantities of light inputted to the third PD 312 and the fourth PD 314. In addition, when the ambient illuminance of the electronic device 101 is greater than or equal to the threshold value, the processor 120 may control the image sensor 230 operating in the second mode to output the third AF data (or the first V-AF data) corresponding to a quantity of light inputted to the first PD 311 or the second PD 312, and the fourth AF data (or the second V-AF data) corresponding to a quantity of light inputted to the third PD 312 or the fourth PD 314. That is, the processor 120 may use light inputted to two PDs out of the PDs 311, 312, 313, 314 included in the unit pixel 310, or may use light inputted to four PDs according to the ambient illuminance of the electronic device 101. When the ambient illuminance of the electronic device 101 is low, the AF operation may be performed by using light inputted to more PDs, so that accuracy of the AF operation may be enhanced.

FIG. 8 illustrates an example of data that is outputted or acquired by the image sensor and the processor, respectively, in a first mode and a second mode according to an embodiment.

According to an embodiment, the processor 120 may determine an operation mode of the image sensor 230 to the first mode or the second mode. In the disclosure, the first mode may refer to a horizontal auto focus (AF) mode, and the second mode may refer to a vertical auto focus (AF) mode.

According to an embodiment, when the electronic device 101 starts photographing by using a camera module 180 (or starts performing an AF function), the processor 120 may control the image sensor 230 to operate in the first mode. According to an embodiment, in the first mode, the image sensor 230 may output first H-AF data, second H-AF data, and an image frame. The first H-AF data, the second H-AF data, and the image frame may correspond to the first H-AF data, the second H-AF data, and the image frame explained in FIG. 7, respectively.

According to an embodiment, in the first mode, the image sensor 230 may further output a second contrast value (for example, a contrast value of the vertical direction). According to an embodiment, the image sensor 230 may acquire a contract value of the vertical direction based on a difference in brightness between the unit pixels 310. For example, the image sensor 230 may add data read out from four PDs in the unit pixel 310, and then, may calculate a difference in brightness from another unit pixel (for example, a unit pixel disposed thereabove, a unit pixel disposed thereunder). For example, the image sensor 230 may acquire the second contrast value based on data resulting from addition of the data of the four unit pixels 310 (for example, the first H-AF data (L)+the second H-AF data (R)).

According to an embodiment, in the first mode, the processor 120 may acquire first correlation data (for example, correlation data of the horizontal direction) between the first H-AF data and the second H-AF data, based on the first H-AF data and the second H-AF data. The processor 120 may acquire a disparity between the first H-AF data and the second H-AF data, based on the first correlation data. According to an embodiment, the processor 120 may acquire a phase difference between the first H-AF data and the second H-AF data, based on the first correlation data. That is, the processor 120 may acquire a first phase difference of a first direction (horizontal direction), based on the first H-AF data and the second H-AF data, and may perform the AF function (for example, the horizontal AF) based on the first phase difference.

According to an embodiment, in the first mode, the processor 120 may acquire a first contrast value (for example, a contrast value of the horizontal direction). According to an embodiment, the processor 120 may acquire the contrast value of the horizontal direction based on a brightness difference between the unit pixels 310. For example, the image sensor 230 may add data read out from four PDs in the unit pixel 310, and then, may calculate a difference in luminance from another unit pixel (for example, a unit pixel disposed on the left, a unit pixel disposed on the right). For example, the processor 120 may acquire the first contrast value based on data resulting from addition of the data of the four unit pixels 310 (for example, the first H-AF data (L)+the second H-AF data (R)).

According to an embodiment, when the processor 120 determines the operation mode of the image sensor 230 to the second mode, the processor 120 may control the image sensor 230 to operate in the second mode. According to an embodiment, in the second mode, the image sensor 230 may output first V-AF data, second V-AF data, an image frame, second correlation data, and a second contrast value. The first V-AF data, the second V-AF data, the image frame, and the second correlation data may correspond to the first V-AF data, the second V-AF data, the image frame, and the correlation data explained in FIG. 7, respectively.

According to an embodiment, in the second mode, the image sensor 230 may acquire and output the second contrast value (for example, a contrast value of the vertical direction). According to an embodiment, the image sensor 230 may output the second contrast value and the second correlation data through the same channel. Accordingly, when the image sensor 230 operates in the first mode, the second contrast value may not be outputted. In an embodiment, the image sensor 230 may output the second contrast value and the second correlation data through separate channels.

According to an embodiment, when the image sensor 230 outputs the second correlation data (for example, correlation data of the vertical direction), the processor 120 may acquire a disparity between the first V-AF data and the second V-AF data, based on the second correlation data acquired from the image sensor 230. According to an embodiment, the processor 120 may acquire a phase difference between the first V-AF data and the second V-AF data, based on the second correlation data. That is, the processor 120 may acquire a second phase difference of a second direction (vertical direction), based on the first V-AF data and the second V-AF data, and may perform the AF function (for example, the vertical AF) based on the second phase difference.

According to an embodiment, in the second mode, the processor 120 may acquire a first contrast value (for example, a contrast value of the horizontal direction). According to an embodiment, even when the processor 120 acquires the first V-AF data and the second V-AF data which are data for performing the vertical AF from the image sensor 230, the processor 120 may acquire the first contrast value which is the contrast value of the horizontal direction. For example, since the processor 120 may acquire the first contrast value based on data resulting from addition of the data of the four unit pixels 310 (for example, the first V-AF data (T)+second V-AF data (B), the first contrast value may be acquired regardless of an operation mode of the image sensor 230.

According to an embodiment, the processor 120 may determine an operation mode of the image sensor 230, based on data acquired from the image sensor 230 and data acquired by the processor 120. According to an embodiment, the processor 120 may determine an operation mode of the image sensor 230 based on contrast information.

According to an embodiment, the processor 120 may identify or acquire a first contrast value corresponding to contrast information of a first direction (for example, the horizontal direction), may receive or acquire a second contrast value corresponding to contrast information of a second direction (for example, the vertical direction) from the image sensor 230, and may determine an operation mode of the image sensor 230 based on the first contrast value and the second contrast value. For example, it is determined that the first contrast value is greater than or equal to the second contrast value, the processor 120 may determine the operation mode of the image sensor 230 to the first mode. When it is determined that the first contrast value is less than the second contrast value, the processor 120 may determine the operation mode of the image sensor 230 to the second mode. For example, the processor 120 may give a weight to the first contrast value. The processor 120 may compare {first contrast value×*a*}(herein, *a* is a weight) and a size of the second contrast value, and may determine an operation mode of the image sensor 230 based on a result of comparing the size. For example, when the first contrast value is less than the second contrast value but the second contrast value is less than a threshold value (for example, a first threshold value), the processor 120 may not change the operation mode of the image sensor 230 from the first mode to the second mode. For example, when the first contrast value is less than the second contrast value, but the first contrast value is greater than or equal to a threshold value (for example, a second threshold value), the processor 120 may not change the operation mode of the image sensor 230 from the first mode to the second mode. The processor 120 may determine an operation mode of the image sensor 230 in various other methods.

According to an embodiment, the processor 120 may identify or acquire the first contrast value corresponding to contrast information of the first direction (for example, the horizontal direction), and may determine an operation mode of the image sensor 230 based on whether the first contrast value is greater than or equal to a threshold value. For example, when the image sensor 230 operates in the first mode, if the processor 120 does not acquire the second contrast value, the processor 120 may determine an operation mode of the image sensor 230 based on the first contrast value. According to an embodiment, the processor 120 may determine the operation mode of the image sensor 230 to the first mode in response to the first contrast value being greater than or equal to a threshold value. In response to the first contrast value being less than the threshold value, the processor 120 may determine the operation mode of the image sensor 230 to the second mode. The processor 120 may acquire the second contrast value while controlling the image sensor 230 to operate in the second mode, and may determine an operation mode of the image sensor 230 based on the first contrast value and the second contrast value.

According to an embodiment, when the processor 120 acquires a first image frame, AF data associated with the first image frame, a contrast value associated with the first image frame, the processor 120 may determine (for example, change or maintain) an operation mode of the image sensor 230 for photographing a second image frame which is subsequent to the first image frame. For example, the second image frame may be the next image frame of the first image frame, or an image frame that comes after a predetermined number of image frame after first image frame.

According to an embodiment, the processor 120 may determine an operation mode of the image sensor 230 in every image frame, and may determine an operation mode of the image sensor 230 when a specific condition is satisfied. For example, the processor 120 may determine an operation mode of the image sensor 230 when a change of a predetermined level or higher is detected from a subject which is being photographed (for example, when the subject is changed). For example, the processor 120 may determine an operation mode of the image sensor 230 when a change as a result of performing auto focus (AF), auto exposure (AE), auto white balance (AWB) (3A) for an image which is being photographed is greater than or equal to a predetermined level, and/or when a change according to 3A is greater than or equal to a predetermined level. For example, when an output of a function of recognizing a subject like a face detector is changed, the processor 120 may determine an operation mode of the image sensor 230. According to an embodiment, the function of recognizing a subject may be configured as at least part of the processor 120, or may be performed in a separate processor which is managed independently of the processor 120.

According to an embodiment, a contrast value of the disclosure (for example, a first contrast value, a second contrast value) may include a brightness difference, an illuminance difference, a luminance brightness or a difference in color. That is, when an edge of the vertical direction having a great brightness difference is added to a subject that the electronic device 101 is photographing, the first contrast value may increase. In addition, when an edge of the horizontal direction having a great difference in color is added to the subject, the second contrast value may increase. According to an embodiment, the contrast value of the disclosure may be substituted with an edge-related parameter. For example, the edge-related parameter may be a parameter indicating whether a direction of an edge included in a subject that the electronic device 101 is photographing is the horizontal direction or the vertical direction.

According to an embodiment, the processor 120 may determine an operation mode of the image sensor 230, based on a contrast value (for example, a first contrast value, a second contrast value) corresponding to all areas of an image frame, or may determine an operation mode of the image sensor 230 based on a contrast value corresponding some areas of the image frame. For example, the processor 120 may determine a region of interest (ROI) in a field of view (FOV) that the electronic device 101 is photographing, and may determine an operation mode of the image sensor 230 based on a contrast value acquired from unit pixels 310 included in the ROI.

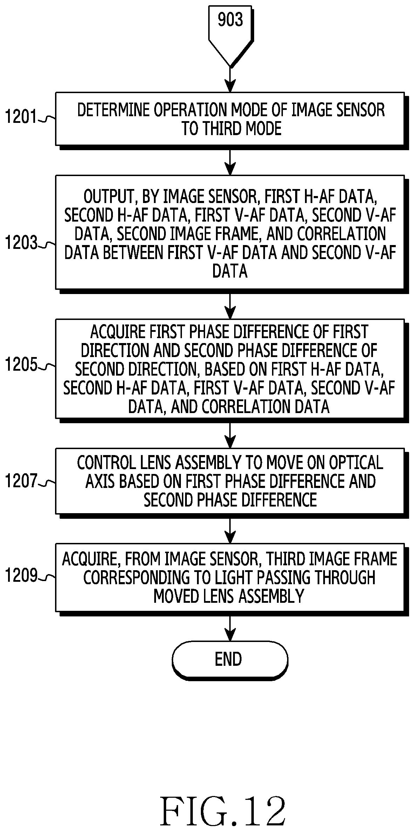

According to an embodiment, although FIG. 8 illustrates that the operation mode of the image sensor 230 is the first mode or the second mode, the operation mode of the image sensor 230 may further include a third mode. For example, when it is difficult to focus on a subject only with horizontal AF or vertical AF, the processor 120 may determine an operation mode of the image sensor 230 to the third mode. The third mode will be described below with reference to FIG. 12.

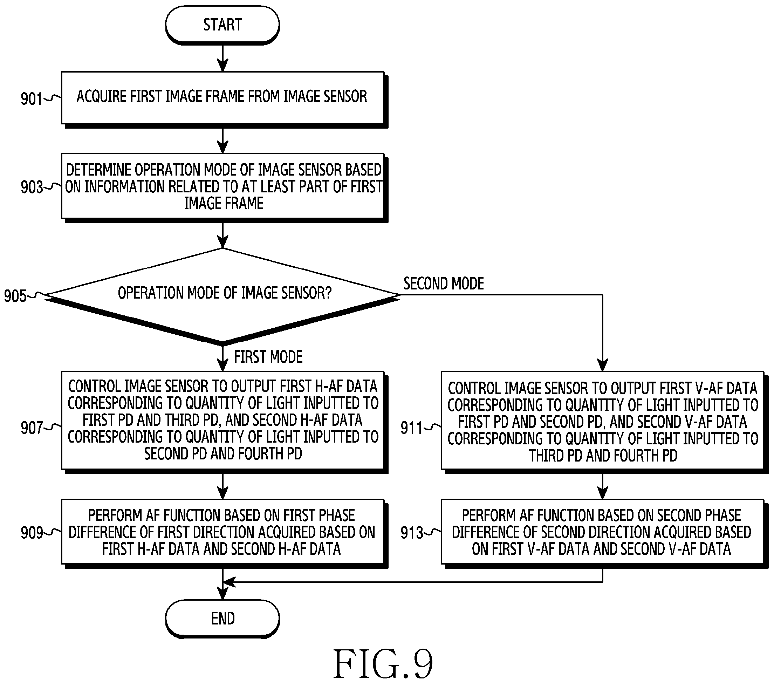

FIG. 9 is a flowchart illustrating a flow of operations of performing, by the processor, horizontal AF or vertical AF according to an embodiment. In the disclosure, the first mode may indicate horizontal AF, and the second mode may indicate vertical AF. It may be understood that the operations illustrated in FIG. 9 are performed by the electronic device 101 or the processor 120.

According to an embodiment, in operation 901, the processor 120 may acquire a first image frame from the image sensor 230. According to an embodiment, in operation 903, the processor 120 may determine an operation mode of the image sensor 230, based on information related to a least part of the first image frame. For example, the processor 120 may acquire contrast information of the first image frame by analyzing the first image frame, and may determine an operation mode of the image sensor 230 based on the contrast information of the first image frame. For example, the processor 120 may determine an operation mode of the image sensor 230, based on a first contrast value, a second contrast value which are acquired along with the first image frame. The processor 120 may determine an operation mode of the image sensor 230 by using at least one of the first contrast value, which is received from the image sensor 230, or the second contrast value which is calculated (or identified) by the processor 120 based on the first image frame.

According to an embodiment, when the processor 120 determines the operation mode of the image sensor 230 to the first mode in operation 905, the processor 120 may perform operation 907 and operation 909, and, when the operation mode of the image sensor 230 is determined to the second mode, the processor 120 may perform operation 911 and operation 913.

According to an embodiment, in operation 907, in response to the operation mode of the image sensor 230 being determined to the first mode, the processor 120 may control the image sensor 230 to output first H-AF data which corresponds to quantities of light inputted to the first PD 311 and the third PD 313, and second H-AF data which corresponds to quantities of light inputted to the second PD 312 and the fourth PD 314. According to an embodiment, in response to the operation mode of the image sensor 230 being determined to the first mode, the processor 120 may control the image sensor 230 to output first H-AF data which is acquired by reading out from the first PD 311 and the third PD 313, and second H-AF data which is acquired by reading out from the second PD 312 and the fourth PD 314. The first H-AF data and the second H-AF data may correspond to the first H-AF data and the second H-AF data explained in FIGS. 7 and 8.

According to an embodiment, in operation 909, the processor 120 may perform an AF function based on a first phase difference of a first direction which is acquired based on the first H-AF data and the second H-AF data. For example, the processor 120 may acquire first correlation data (for example, correlation data of the horizontal direction) based on the first H-AF data and the second H-AF data, and may acquire the first phase difference of the first direction (for example, the horizontal direction) based on the first correlation data. The processor 120 may perform an AF function (for example, horizontal AF) based on the first phase difference.

According to an embodiment, in operation 911, in response to the operation mode of the image sensor 230 to the second mode, the processor 120 may control the image sensor 230 to output first V-AF data which corresponds to quantities of light inputted to the first PD 311 and the second PD 312, and second V-AF data which corresponds to quantities of light inputted to the third PD 313 and the fourth PD 314. According to an embodiment, in response to the operation mode of the image sensor 230 being determined to the second mode, the processor 120 may control the image sensor 230 to output first V-AF data which is acquired by reading out from the first PD 311 and the second PD 312, and second V-AF data which is acquired by reading out from the third PD 313 and the fourth PD 314. The first V-AF data and the second V-AF data may correspond to the first V-AF data and the second V-AF data explained in FIGS. 7 and 8.

According to an embodiment, in operation 913, the processor 120 may perform an AF function based on a second phase difference of a second direction which is acquired based on the first V-AF data and the second V-AF data. For example, the processor 120 may acquire, from the image sensor 230, second correlation data (for example, correlation data of the vertical direction) acquired based on the first V-AF data and the second V-AF data, and may acquire the second phase difference of the second direction (for example, the vertical direction) based on the second correlation data. The processor 120 may perform an AF function (for example, vertical AF) based on the second phase difference.

According to an embodiment, comparing the first mode of operation 907 and operation 909 and the second mode of operation 911 and operation 913, the processor 120 may determine a readout direction of the unit pixel 310 according to an operation mode of the image sensor 230. In this case, the readout direction may indicate a direction in which two PDs from which data is read out among the four PDs in one unit pixel 310 are selected. That is, in the first mode, the image sensor 230 may read out from a TL and a BL concurrently and may read out from a TR and a BR concurrently. In addition, in the second mode, the image sensor 230 may read out from the TL and the TR concurrently, and may read out from the BL and the BR concurrently. The TL may correspond to the first PD 311, the TR may correspond to the second PD 312, the BL may correspond to the third PD 313, and the BR may correspond to the fourth PD 314.

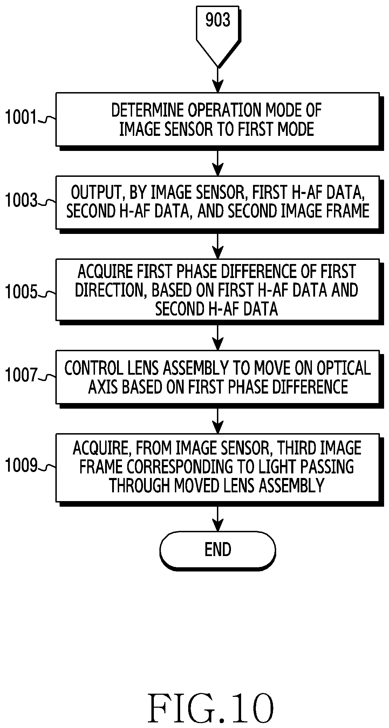

FIG. 10 is a flowchart illustrating a flow of operations performed by the image sensor in the first mode according to an embodiment. It will be understood that operations illustrated in FIG. 10 are performed by the electronic device 101, the processor 120, or the image sensor 230.

According to an embodiment, it will be understood that operations illustrated in FIG. 10 are performed after operation 901 and operation 903 of FIG. 9.

According to an embodiment, in operation 1001, the processor 120 may determine the operation mode of the image sensor 230 to the first mode. The processor 120 may determine the operation mode of the image sensor 230 to the first mode, based on the first image frame.

According to an embodiment, in operation 1003, the image sensor 230 may output first H-AF data, second H-AF data, and a second image frame in the first mode. The processor 120 may acquire the first H-AF data, the second H-AF data, and the second image frame from the image sensor 230. For example, the processor 120 may control the image sensor 230 to enable the first H-AF block 711 and/or the second H-AF block 712 among the blocks of FIG. 7, and to disable the first V-AF block 721 and the second V-AF block 722. According to an embodiment, the second image frame may be an image frame related to the first H-AF data, the second H-AF data. For example, the second image frame, the first H-AF data, the second H-AF data may be understood as being generated/acquired from pixel data which is photographed by exposing PDs at a specific time.

According to an embodiment, in operation 1005, the processor 120 may acquire a first phase difference of a first direction (for example, the horizontal direction), based on the first H-AF data and the second H-AF data. The processor 120 may acquire correlation data (for example, first correlation data) between the first H-AF data and the second H-AF data, based on the first H-AF data and the second H-AF data, and may acquire the first phase difference of the first direction based on the first correlation data. According to an embodiment, in operation 1007, the processor 120 may control the lens assembly 210 to move on an optical axis (for example, z-axis) based on the first phase difference. For example, the processor 120 may measure a distance to a subject based on the first phase difference, and may determine a position where the lens assembly 210 should arrive in order to focus on the subject, and may control the camera module 180 to move the lens assembly 210 to the corresponding position.

According to an embodiment, in operation 1009, the processor 120 may acquire a third image frame corresponding to light passing through the lens assembly 210 which is moved from the image sensor 230.

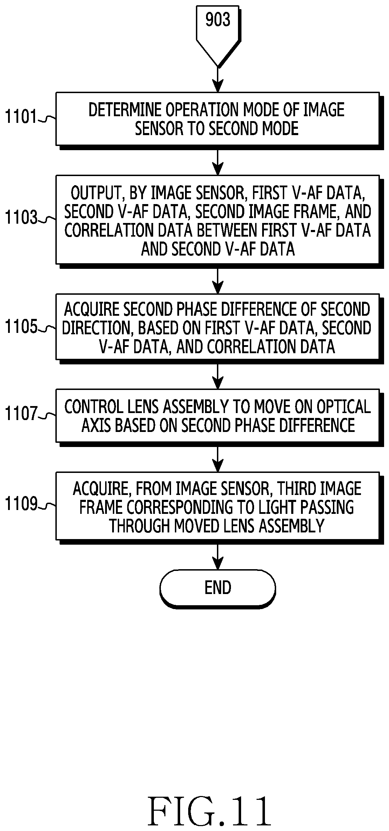

FIG. 11 is a flowchart illustrating a flow of operations performed by the image sensor in the second mode according to an embodiment. It will be understood that operations illustrated in FIG. 11 are performed by the electronic device 101, the processor 120, or the image sensor 230.

According to an embodiment, it will be understood that operations illustrated in FIG. 11 are performed after operation 901 and operation 903 of FIG. 9.

According to an embodiment, in operation 1101, the processor 120 may determine the operation mode of the image sensor 230 to the second mode. The processor 120 may determine the operation mode of the image sensor 230 to the second mode, based on the first image frame.

According to an embodiment, in operation 1103, the image sensor 230 may output first V-AF data, second V-AF data, a second image frame, and correlation data (for example, second correlation data) between the first V-AF data and the second V-AF data in the second mode. The processor 120 may acquire the first V-AF data, the second V-AF data, the second image frame, and the correlation data (for example, second correlation data) between the first V-AF data and the second V-AF data from the image sensor 230. For example, the processor 120 may control the image sensor 230 to enable the first V-AF block 721 and/or the second V-AF block 722 among the blocks of FIG. 7, to enable the correlation calculation block 730, and to disable the first H-AF block 711 and the second H-AF block 712. According to an embodiment, the second image frame may be an image frame related to the first V-AF data, the second V-AF data. For example, the second image frame, the first V-AF data, the second V-AF data may be understood as being generated/acquired from pixel data which is photographed by exposing PDs at a specific time.

According to an embodiment, in operation 1105, the processor 120 may acquire a second phase difference of a second direction (for example, the vertical direction), based on the first V-AF data, the second V-AF data, and the second correlation data. According to an embodiment, in operation 1107, the processor 120 may control the lens assembly 210 to move on an optical axis (for example, z-axis) based on the second phase difference. For example, the processor 120 may measure a distance to a subject based on the second phase difference, and may determine a position where the lens assembly 210 should arrive in order to focus on the subject, and may control the camera module 180 to move the lens assembly 210 to the corresponding position.

According to an embodiment, in operation 1109, the processor 120 may acquire a third image frame corresponding to light passing through the lens assembly 210 which is moved from the image sensor 230.

FIG. 12 is a flowchart illustrating a flow of operations performed by the image sensor in the third mode according to an embodiment. It will be understood that operations illustrated in FIG. 12 are performed by the electronic device 101, the processor 120, or the image sensor 230.

According to an embodiment, in operation 1201, the processor 120 may determine the operation mode of the image sensor 230 to the third mode. The processor 120 may determine the operation mode of the image sensor 230 to the third mode, based on the first image frame. For example, when it is determined that there is no difference or very little difference between a first contrast value and a second contrast value, the processor 120 may determine the operation mode of the image sensor 230 to the third mode. For example, when a small edge of a slope of about 45 degrees is included in a subject that the electronic device 101 is photographing, the processor 120 may determine the operation mode of the image sensor 230 to the third mode.

According to an embodiment, in operation 1203, in the third mode, the image sensor 230 may output first H-AF data, second H-AF data, first V-AF data, second V-AF data, a second image frame, and correlation data (for example, second correlation data) between the first V-AF data and the second V-AF data. The processor 120 may acquire, from the image sensor 230, the first H-AF data, the second H-AF data, the first V-AF data, the second V-AF data, the second image frame, and the correlation data (for example, second correlation data) between the first V-AF data and the second V-AF data. For example, the processor 120 may control the image sensor 230 to enable all blocks 711, 712, 721, 722, 730 of FIG. 7 or to enable some 712, 722, 730 of the blocks.

According to an embodiment, in operation 1205, the processor 120 may acquire a first phase difference of a first direction and a second phase difference of a second direction, based on the first H-AF data, the second H-AF data, the first V-AF data, the second V-AF data, and the second correlation data. For example, the processor 120 may acquire first correlation data (for example, correlation data of the horizontal direction) based on the first H-AF data and the second H-AF data, and may acquire the first phase difference of the first direction (for example, the horizontal direction) based on the first correlation data. In addition, the processor 120 may acquire the second phase difference of the second direction (for example, the vertical direction) based on second correlation data (for example, correlation data of the vertical direction) between the first V-AF data and the second V-AF data.

According to an embodiment, in operation 1207, the processor 120 may control the lens assembly 210 to move on an optical axis based on the first phase difference and the second phase difference. According to an embodiment, in operation 1209, the processor 120 may acquire a third image frame corresponding to light passing through the lens assembly 210 which is moved from the image sensor 230.

According to an embodiment, when the processor 120 determines the operation mode of the image sensor 230 to the third mode, a capacity of AF data (for example, the first H-AF data, the second H-AF data, the first V-AF data, the second V-AF data) outputted from the image sensor 230 may increase compare to that in the first mode or the second mode. In order to prevent a calculation speed from being reduced when the operation mode of the image sensor 230 is the third mode, the processor 120 may control the image sensor 230 to output AF data of a different direction in every unit pixel 310, or may control the image sensor 230 to output AF data of different directions over two or more frames. For example, the processor 120 may control the image sensor 230 to output the first H-AF data and the second H-AF data through a first unit pixel and to output the first V-AF data and the second V-AF data through a second unit pixel. For example, the processor 120 may control the image sensor 230 to output the first H-AF data and the second H-AF data related to a specific image frame, and to output the first V-AF data and the second V-AF data related to an image frame subsequent to the specific image.

According to an embodiment, when it is determined that there is no difference or very little difference between the first contrast value and the second contrast value, the processor 120 may determine the operation mode of the image sensor 230 to a fourth mode. For example, when an edge of a slope of about 45 degrees is included in a subject that the electronic device 101 is photographing (for example, when a contrast characteristic in a longitudinal direction or a traverse direction is relatively low and a contrast characteristic is relatively high in the direction of 45 degrees), the processor 120 may determine the operation mode of the image sensor 230 to the fourth mode. According to an embodiment, in response to the operation mode of the image sensor 230 being determined to the fourth mode, the processor 120 may control the image sensor 230 to output AF data corresponding to a quantity of light inputted to the first PD 311 and AF data corresponding to a quantity of light inputted to the fourth PD 314, and may perform an AF operation of a diagonal direction by using the AF data acquired from the image sensor 230. According to an embodiment, in response to the operation mode of the image sensor 230 being determined to the fourth mode, the processor 120 may control the image sensor 230 to output AF data corresponding to a quantity of light inputted to the second PD 312, and AF data corresponding to a quantity of light inputted to the third PD, and may perform an AF operation of a diagonal direction by using the AF data acquired from the image sensor 230. In addition, the processor 120 may use AF data that is read out from at least some PDs among the PDs included in the unit pixel 310 in order to acquire phase differences of various directions.

According to an embodiment, an electronic device 101 may include an image sensor 230 including a plurality of unit pixels 310, and at least one processor 120 electrically connected with the image sensor. A first unit pixel of the plurality of unit pixels may include: a micro lens 511; and a first photodiode (PD) 311, a second PD 312 disposed in a first direction of the first PD, a third PD 313 disposed in a second direction of the first PD, and a fourth PD 314 disposed in the second direction of the second PD, the first PD, the second PD, the third PD, and the fourth PD being disposed under the micro lens. The at least one processor may: acquire a first image frame from the image sensor; determine an operation mode of the image sensor, based on information related to at least part of the first image frame; in response to the operation mode of the image sensor being determined to a first mode, control the image sensor to output first auto focus (AF) data corresponding to a quantity of light inputted to at least one PD of the first PD or the third PD, and second AF data corresponding to a quantity of light inputted to at least one PD of the second PD or the fourth PD, and perform an AF function based on a first phase difference of the first direction which is acquired based on the first AF data and the second AF data; and, in response to the operation mode of the image sensor being determined to a second mode, control the image sensor to output third AF data corresponding to a quantity of light inputted to at least one PD of the first PD or the second PD, and fourth AF data corresponding to a quantity of light inputted to at least one PD of the third PD or the fourth PD, and perform an AF function based on a second phase difference of the second direction which is acquired based on the third AF data and the fourth AF data.

In the electronic device according to an embodiment, the information related to at least part of the first image frame may be contrast information of the first image frame.

In the electronic device according to an embodiment, the at least one processor may: identify a first contrast value corresponding to contrast information of the first direction associated with the first image frame; acquire a second contrast value corresponding to contrast information of the second direction associated with the first image frame from the image sensor; and, based on the first contrast value and the second contrast value, determine the operation mode of the image sensor.

In the electronic device according to an embodiment, the at least one processor may: identify a first contrast value corresponding to contrast information of the first direction associated with the first image frame; and determine the operation mode of the image sensor, based on whether the first contrast value is less than a threshold value.

In the electronic device according to an embodiment, the at least one processor may: in response to the first contrast value being greater than or equal to the threshold value, determine the operation mode of the image sensor to the first mode; in response to the first contrast value being less than the threshold value, determine the operation mode of the image sensor to the second mode; while controlling the image sensor to operate in the second mode, acquire a second contrast value corresponding to contrast information of the second direction associated with the first image frame; and determine the operation mode of the image sensor, based on the first contrast value and the second contrast value.

In the electronic device according to an embodiment, the first unit pixel may include: one floating diffusion (FD) connected with the first PD, the second PD, the third PD, and the fourth PD; and a first transfer gate (TG) configured to connect the first PD and the FD, a second TG configured to connect the second PD and the FD, a third TG configured to connect the third PD and the FD, and a fourth TG configured to connect the fourth PD and the FD. The image sensor may: when the operation mode of the image sensor is the first mode, switch at least one TG of the first TG or the third TG into an ON state and acquire the first AF data corresponding to at least one PD of the first PD or the third PD, and switch at least one TG of the second TG or the fourth TG to an ON state, and acquire the second AF data corresponding to at least one PD of the second PD or the fourth PD, and, when the operation mode of the image sensor is the second mode, switch at least one TG of the first TG or the second TG into an ON state and acquire the third AF data corresponding to at least one PD of the first PD or the second PD, and switch at least one TG of the third TG or the fourth TG into an ON state and acquire the fourth AF data corresponding to at least one PD of the third PD or the fourth PD.

In the electronic device according to an embodiment, the image sensor may: acquire first readout data, second readout data, third readout data, and fourth readout data by reading out from the first PD, the second PD, the third PD, and the fourth PD, respectively; when the operation mode of the image sensor is the first mode, acquire the first AF data resulting from addition of the first readout data and the third readout data, and the second AF data resulting from addition of the second readout data and the fourth readout data; and, when the operation mode of the image sensor is the second mode, acquire the third AF data resulting from addition of the first readout data and the second readout data, and the fourth AF data resulting from addition of the third readout data and the fourth readout data.

The electronic device according to an embodiment may further include a lens assembly which is electrically connected with the at least one processor and includes at least one lens aligned along an optical axis. The at least one processor may: determine the operation mode of the image sensor to the first mode, based on the information related to at least part of the first image frame; acquire, from the image sensor, the first AF data, the second AF data, and a second image frame related to the first AF data and the second AF data; acquire the first phase difference of the first direction, based on the first AF data and the second AF data; control the lens assembly to move on the optical axis based on the first phase difference; and acquire, from the image sensor, a third image frame corresponding to light passing through the moved lens assembly.

The electronic device according to an embodiment may further include a lens assembly which is electrically connected with the at least one processor and includes at least one lens aligned along an optical axis. The at least one processor may: determine the operation mode of the image sensor to the second mode based on the first image frame; acquire, from the image sensor, the third AF data, the fourth AF data, a second image frame related to the third AF data and the fourth AF data, and correlation data between the third AF data and the fourth AF data; acquire the second phase difference of the second direction, based on the third AF data, the fourth AF data, and the correlation data; control the lens assembly to move on the optical axis, based on the second phase difference; and acquire, from the image sensor, a third image frame corresponding to light passing through the moved lens assembly.

The electronic device according to an embodiment may further include an illuminance sensor configured to measure ambient illuminance of the electronic device, and the at least one processor may: determine whether the ambient illuminance of the electronic device is greater than or equal to a threshold value by using the illuminance sensor; in response to the ambient illuminance of the electronic device being greater than or equal to the threshold value, control the image sensor operating in the first mode to output the first AF data corresponding to a quantity of light inputted to any one PD of the first PD or the third PD, and the second AF data corresponding to a quantity of light inputted to any one PD of the second PD or the fourth PD; and, in response to the ambient illuminance of the electronic device being less than the threshold value, control the image sensor operating in the first mode to output the first AF data corresponding to a quantity of light inputted to the first PD and the third PD, and the second AF data corresponding to a quantity of light inputted to the second PD and the fourth PD.

According to an embodiment, an operating method of an electronic device 100 may include: acquiring a first image frame through an image sensor 230, the image sensor including a plurality of unit pixels, a first unit pixel 310 of the plurality of unit pixels including: a first PD 311, a second PD 312 disposed in a first direction of the first PD, a third PD 313 disposed in a second direction of the first PD, and a fourth PD 314 disposed in the second direction of the second PD; determining an operation mode of the image sensor, based on information related to at least part of the first image frame; in response to the operation mode of the image sensor being determined to a first mode, controlling the image sensor to output first AF data corresponding to a quantity of light inputted to at least one PD of the first PD or the third PD, and second AF data corresponding to a quantity of light inputted to at least one PD of the second PD or the fourth PD, and performing an AF function based on a first phase difference of the first direction which is acquired based on the first AF data and the second AF data; and, in response to the operation mode of the image sensor being determined to a second mode, controlling the image sensor to output third AF data corresponding to a quantity of light inputted to at least one PD of the first PD or the second PD, and fourth AF data corresponding to a quantity of light inputted to at least one PD of the third PD or the fourth PD, and performing an AF function based on a second phase difference of the second direction which is acquired based on the third AF data and the fourth AF data.

In the operating method of the electronic device according to an embodiment, determining the operation mode of the image sensor based on the first image frame may include: identifying a first contrast value corresponding to contrast information of the first direction associated with the first image frame; acquiring a second contrast value corresponding to contrast information of the second direction associated with the first image frame through the image sensor; and, based on the first contrast value and the second contrast value, determining the operation mode of the image sensor.

In the operating method of the electronic device according to an embodiment, determining the operation mode of the image sensor based on the information related to at least part of the first image frame may include: identifying a first contrast value corresponding to contrast information of the first direction associated with the first image frame; and determining the operation mode of the image sensor, based on whether the first contrast value is less than a threshold value.

The operating method of the electronic device according to an embodiment may include: determining the operation mode of the image sensor to the first mode, based on the information related to at least part of the first image frame; acquiring, through the image sensor, the first AF data, the second AF data, and a second image frame related to the first AF data and the second AF data; acquiring the first phase difference of the first direction, based on the first AF data and the second AF data; controlling a lens assembly to move on an optical axis based on the first phase difference; and acquiring, through the image sensor, a third image frame corresponding to light passing through the moved lens assembly.

The operating method of the electronic device according to an embodiment may include: determining the operation mode of the image sensor to the second mode based on the first image frame; acquiring, through the image sensor, the third AF data, the fourth AF data, a second image frame related to the third AF data and the fourth AF data, and correlation data between the third AF data and the fourth AF data; acquiring the second phase difference of the second direction, based on the third AF data, the fourth AF data, and the correlation data; controlling a lens assembly to move on an optical axis, based on the second phase difference; and acquiring, through the image sensor, a third image frame corresponding to light passing through the moved lens assembly.

According to an embodiment, an electronic device may include: an image sensor including a plurality of unit pixels; and at least one processor electrically connected with the image sensor. A first unit pixel of the plurality of unit pixels may include a first PD, a second PD disposed in a first direction of the first PD, a third PD disposed in a second direction of the first PD, and a fourth PD disposed in the second direction of the second PD. The at least one processor may: acquire a first image frame from the image sensor; determine an operation mode of the image sensor, based on the first image frame; in response to the operation mode of the image sensor being determined to a first mode, control the image sensor to output first H-AF data which is acquired by reading out from the first PD and the third PD, and second H-AF data which is acquired by reading out from the second PD and the fourth PD, and perform an auto focus (AF) function based on a first phase difference of the first direction which is acquired based on the first H-AF data and the second H-AF data; and, in response to the operation mode of the image sensor being determined to a second mode, control the image sensor to output first V-AF data which is acquired by reading out from the first PD and the second PD, and second V-AF data which is acquired by reading out from the third PD and the fourth PD, and perform an AF function based on a second phase difference of the second direction which is acquired based on the first V-AF data and the second V-AF data

In the electronic device according to an embodiment, the first unit pixel may include: a micro lens configured to cover the first PD, the second PD, the third PD, and the fourth PD; and a color filter disposed between the micro lens and the first PD, the second PD, the third PD, and the fourth PD.

In the electronic device according to an embodiment, when the operation mode of the image sensor is the first mode, the image sensor may: acquire the first H-AF data by reading out from the first PD and the third PD through an analogue sum; acquire the second H-AF data by reading out from the second PD and the fourth PD through an analogue sum; and provide the first H-AF data and the second H-AF data to the at least one processor.

In the electronic device according to an embodiment, when the operation mode of the image sensor is the second mode, the image sensor may: acquire the first V-AF data by reading out from the first PD and the second PD through an analogue sum; acquire the second V-AF data by reading out from the third PD and the fourth PD through an analogue sum; and provide the first V-AF data and the second V-AF data to the at least one processor.

In the electronic device according to an embodiment, the image sensor may further include: a second unit pixel disposed in the first direction of the first unit pixel; a third unit pixel disposed in the second direction of the first unit pixel; and a fourth unit pixel disposed in the second direction of the second unit pixel. Colors of color filters corresponding to the first unit pixel, the second unit pixel, the third unit pixel, and the fourth unit pixel may be identical to one another.

## Claims

1. An electronic device comprising:
an image sensor comprising a plurality of unit pixels; and
at least one processor electrically connected with the image sensor,
wherein a first unit pixel of the plurality of unit pixels comprises: a micro lens; and a first photodiode (PD), a second PD disposed in a first direction of the first PD, a third PD disposed in a second direction of the first PD, and a fourth PD disposed in the second direction of the second PD, the first PD, the second PD, the third PD, and the fourth PD being disposed under the micro lens,
wherein the at least one processor is configured to:
acquire a first image frame from the image sensor;
determine an operation mode of the image sensor, based on information related to at least part of the first image frame;
in response to the operation mode of the image sensor being determined to a first mode, control the image sensor to output first auto focus (AF) data corresponding to a quantity of light inputted to at least one PD of the first PD or the third PD, and second AF data corresponding to a quantity of light inputted to at least one PD of the second PD or the fourth PD, and perform an AF function based on a first phase difference of the first direction which is acquired based on the first AF data and the second AF data; and
in response to the operation mode of the image sensor being determined to a second mode, control the image sensor to output third AF data corresponding to a quantity of light inputted to at least one PD of the first PD or the second PD, and fourth AF data corresponding to a quantity of light inputted to at least one PD of the third PD or the fourth PD, and perform an AF function based on a second phase difference of the second direction which is acquired based on the third AF data and the fourth AF data.

2. The electronic device of claim 1, wherein the information related to at least part of the first image frame is contrast information of the first image frame.

3. The electronic device of claim 1, wherein the at least one processor is configured to:
identify a first contrast value corresponding to contrast information of the first direction associated with the first image frame;
acquire a second contrast value corresponding to contrast information of the second direction associated with the first image frame from the image sensor; and
based on the first contrast value and the second contrast value, determine the operation mode of the image sensor.

4. The electronic device of claim 1, wherein the at least one processor is configured to:
identify a first contrast value corresponding to contrast information of the first direction associated with the first image frame; and
determine the operation mode of the image sensor, based on whether the first contrast value is less than a threshold value.

5. The electronic device of claim 4, wherein the at least one processor is configured to:
in response to the first contrast value being greater than or equal to the threshold value, determine the operation mode of the image sensor to the first mode;
in response to the first contrast value being less than the threshold value, determine the operation mode of the image sensor to the second mode;
while controlling the image sensor to operate in the second mode, acquire a second contrast value corresponding to contrast information of the second direction associated with the first image frame; and
determine the operation mode of the image sensor, based on the first contrast value and the second contrast value.

6. The electronic device of claim 1, wherein the first unit pixel comprises:
one floating diffusion (FD) connected with the first PD, the second PD, the third PD, and the fourth PD; and
a first transfer gate (TG) configured to connect the first PD and the FD, a second TG configured to connect the second PD and the FD, a third TG configured to connect the third PD and the FD, and a fourth TG configured to connect the fourth PD and the FD, and
wherein the image sensor is configured to:
when the operation mode of the image sensor is the first mode, switch at least one TG of the first TG or the third TG into an ON state and acquire the first AF data corresponding to at least one PD of the first PD or the third PD, and switch at least one TG of the second TG or the fourth TG to an ON state, and acquire the second AF data corresponding to at least one PD of the second PD or the fourth PD, and
when the operation mode of the image sensor is the second mode, switch at least one TG of the first TG or the second TG into an ON state and acquire the third AF data corresponding to at least one PD of the first PD or the second PD, and switch at least one TG of the third TG or the fourth TG into an ON state and acquire the fourth AF data corresponding to at least one PD of the third PD or the fourth PD.

7. The electronic device of claim 1, wherein the image sensor is configured to:
acquire first readout data, second readout data, third readout data, and fourth readout data by reading out from the first PD, the second PD, the third PD, and the fourth PD, respectively;
when the operation mode of the image sensor is the first mode, acquire the first AF data resulting from addition of the first readout data and the third readout data, and the second AF data resulting from addition of the second readout data and the fourth readout data; and
when the operation mode of the image sensor is the second mode, acquire the third AF data resulting from addition of the first readout data and the second readout data, and the fourth AF data resulting from addition of the third readout data and the fourth readout data.

8. The electronic device of claim 1, further comprising a lens assembly which is electrically connected with the at least one processor and comprises at least one lens aligned along an optical axis,
wherein the at least one processor is configured to:
determine the operation mode of the image sensor to the first mode, based on the information related to at least part of the first image frame;
acquire, from the image sensor, the first AF data, the second AF data, and a second image frame related to the first AF data and the second AF data;
acquire the first phase difference of the first direction, based on the first AF data and the second AF data;
control the lens assembly to move on the optical axis based on the first phase difference; and
acquire, from the image sensor, a third image frame corresponding to light passing through the moved lens assembly.

9. The electronic device of claim 1, further comprising a lens assembly which is electrically connected with the at least one processor and comprises at least one lens aligned along an optical axis,
wherein the at least one processor is configured to:
determine the operation mode of the image sensor to the second mode based on the first image frame;
acquire, from the image sensor, the third AF data, the fourth AF data, a second image frame related to the third AF data and the fourth AF data, and correlation data between the third AF data and the fourth AF data;
acquire the second phase difference of the second direction, based on the third AF data, the fourth AF data, and the correlation data;
control the lens assembly to move on the optical axis, based on the second phase difference; and
acquire, from the image sensor, a third image frame corresponding to light passing through the moved lens assembly.

10. The electronic device of claim 1, further comprising an illuminance sensor configured to measure ambient illuminance of the electronic device,
wherein the at least one processor is configured to:
determine whether the ambient illuminance of the electronic device is greater than or equal to a threshold value by using the illuminance sensor;
in response to the ambient illuminance of the electronic device being greater than or equal to the threshold value, control the image sensor operating in the first mode to output the first AF data corresponding to a quantity of light inputted to any one PD of the first PD or the third PD, and the second AF data corresponding to a quantity of light inputted to any one PD of the second PD or the fourth PD; and
in response to the ambient illuminance of the electronic device being less than the threshold value, control the image sensor operating in the first mode to output the first AF data corresponding to a quantity of light inputted to the first PD and the third PD, and the second AF data corresponding to a quantity of light inputted to the second PD and the fourth PD.

11. An operating method of an electronic device, the method comprising:
acquiring a first image frame through an image sensor, the image sensor comprising a plurality of unit pixels, a first unit pixel of the plurality of unit pixels comprising: a first PD, a second PD disposed in a first direction of the first PD, a third PD disposed in a second direction of the first PD, and a fourth PD disposed in the second direction of the second PD;
determining an operation mode of the image sensor, based on information related to at least part of the first image frame;
in response to the operation mode of the image sensor being determined to a first mode, controlling the image sensor to output first AF data corresponding to a quantity of light inputted to at least one PD of the first PD or the third PD, and second AF data corresponding to a quantity of light inputted to at least one PD of the second PD or the fourth PD, and performing an AF function based on a first phase difference of the first direction which is acquired based on the first AF data and the second AF data; and
in response to the operation mode of the image sensor being determined to a second mode, controlling the image sensor to output third AF data corresponding to a quantity of light inputted to at least one PD of the first PD or the second PD, and fourth AF data corresponding to a quantity of light inputted to at least one PD of the third PD or the fourth PD, and performing an AF function based on a second phase difference of the second direction which is acquired based on the third AF data and the fourth AF data.

12. The method of claim 11, wherein determining the operation mode of the image sensor based on the first image frame comprises:
identifying a first contrast value corresponding to contrast information of the first direction associated with the first image frame;
acquiring a second contrast value corresponding to contrast information of the second direction associated with the first image frame through the image sensor; and
based on the first contrast value and the second contrast value, determining the operation mode of the image sensor.

13. The method of claim 11, wherein determining the operation mode of the image sensor based on the information related to at least part of the first image frame comprises:
identifying a first contrast value corresponding to contrast information of the first direction associated with the first image frame; and
determining the operation mode of the image sensor, based on whether the first contrast value is less than a threshold value.

14. The method of claim 11, comprising:
determining the operation mode of the image sensor to the first mode, based on the information related to at least part of the first image frame;
acquiring, through the image sensor, the first AF data, the second AF data, and a second image frame related to the first AF data and the second AF data;
acquiring the first phase difference of the first direction, based on the first AF data and the second AF data;
controlling a lens assembly to move on an optical axis based on the first phase difference; and
acquiring, through the image sensor, a third image frame corresponding to light passing through the moved lens assembly.

15. The method of claim 11, comprising:
determining the operation mode of the image sensor to the second mode based on the first image frame;
acquiring, through the image sensor, the third AF data, the fourth AF data, a second image frame related to the third AF data and the fourth AF data, and correlation data between the third AF data and the fourth AF data;
acquiring the second phase difference of the second direction, based on the third AF data, the fourth AF data, and the correlation data;
controlling a lens assembly to move on an optical axis, based on the second phase difference; and
acquiring, through the image sensor, a third image frame corresponding to light passing through the moved lens assembly.
